# EUROPEAN PATENT SPECIFICATION

(11) **EP 1 903 839 B1**
(45) Date of publication and mention of the grant of the patent: **20.04.2016**
(21) Application number: 07018384.3
(22) Date of filing: 19.09.2007
(51) Int. Cl.: H05K 1/02, H05K 3/34

(54) **A method for producing a printed circuit board with a heat radiating structure**
Verfahren zur Herstellung einer Leiterplatte mit einer wärmeabstrahlenden Struktur
Procédé de production de carte de circuit imprimé avec structure à rayonnement thermique

(30) Priority: 20.09.2006 JP 2006253993
(43) Date of publication of application: 26.03.2008
(73) Proprietor: Sumitomo Wiring Systems, Ltd., Yokkaichi-city, Mie 510-8503 (JP)
(72) Inventor: Sugimura, Yoshiaki, Yokkaichi-city Mie 510-8503 (JP)
(74) Representative: Müller-Boré & Partner Patentanwälte PartG mbB

(56) References cited:
- EP-A- 0 139 431
- EP-A- 0 920 055
- DE-A1- 19 910 500
- JP-A- 2004 127 992
- JP-A- 2005 340 233
- JP-A- 2006 100 483
- US-A- 5 708 566
- US-A1- 2002 131 240
- US-A1- 2004 042 180

## Description

The present invention relates to a heat radiating structure of a printed circuit board and a printed circuit board producing method and is particularly designed to improve the heat radiating capability of a heat generating electronic part such as an IC chip to which a large current is applied and to prevent an occurrence of problems at the time of producing a printed circuit board having the heat radiating capability.

In order to radiate heat generated by an electronic part to be mounted on a printed circuit board, there is provided a structure in which a land portion for soldering is provided on a mounting surface for the electronic part and heat is radiated to the other surface through a through hole formed in the land portion.

For example, Japanese Unexamined Patent Publication No. H09-148691 discloses, as shown in FIGS. 8(A), 8(B) and 8(C), that a copper foil flat pattern 3 is provided one surface 2a of a double-sided circuit board 2 on which a heat generating element 1 is to be mounted, the underside of the heat generating element 1 is secured to the copper foil flat pattern 3 using solder or paste, the copper foil flat pattern 3 is electrically connected to a copper foil flat pattern 5 on another surface 2b through viaholes 4, and heat generated by the heat generating element 1 is radiated from the copper foil flat pattern 5 on the other surface 2b via the copper foil flat pattern 3 and viaholes 4.

With the structure of the above Japanese Unexamined Patent Publication No. H09-148691, the heat generated by the heat generating element 1 is efficiently transferred to the copper foil flat pattern 5 from the copper foil flat pattern 3 through conductive layers 4a formed on the inner circumferential surfaces of the viaholes 4 by plating, thereby improving a heat radiating effect.

However, Japanese Unexamined Patent Publication No. H09-148691simply discloses that the heat generating element 1 is secured to the copper foil flat pattern 3 using paste, solder or the like, and a specific securing method using solder or paste is unclear.

Further, Japanese Unexamined Patent Publication No. 2004-127992 discloses that, after through holes are formed to penetrate a printed circuit board from the top surface to the under surface and the under surface is placed on a base plate, the through holes are filled up by printing resin paste in the through holes from the topside by means of a squeegee so as to prevent solder flowing into the through holes from forming protuberances at the underside.

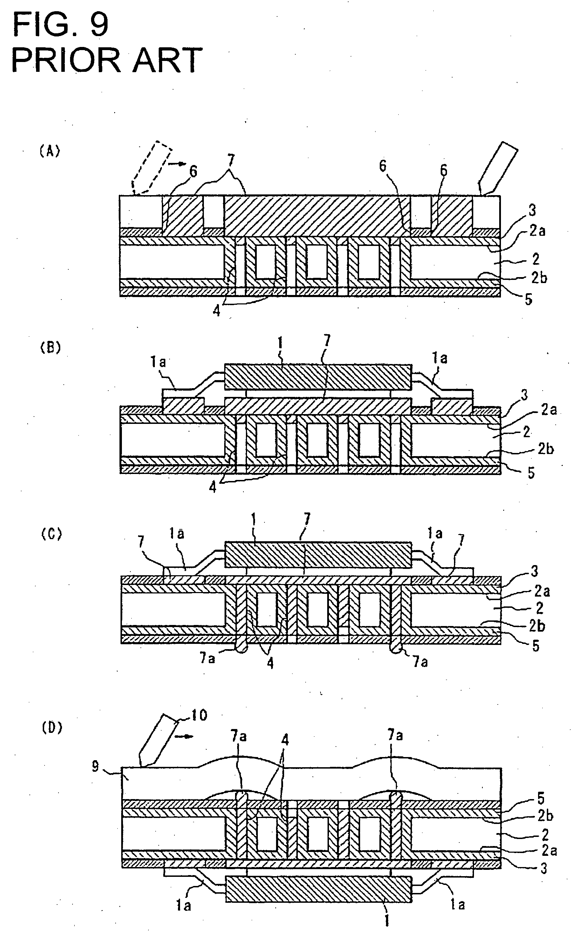

In the printed circuit board having the conductor patterns on both surfaces thereof disclosed in Japanese Unexamined Patent Publication No. H09-148691, the method for securing the heat generating element 1 and the copper foil flat pattern 3 using past or solder is unclear. In the case of securing the copper foil flat pattern 3 to the heat generating element 1 provided with a heat sink for heat radiation and electrical connection on the underside thereof, a process shown in FIGS. 9A to 9D is specifically carried out and the molten solder might flow into the viaholes 4. In such a case, the molten solder might be solidified at the underside and so-called solder balls 7a might project at the underside.

Specifically, cream solder 7 is applied to land portions 6 solder-connected to lead terminals 1a of a heat generating element 1 on one surface 2a of a circuit board 2 and a copper foil flat pattern 3 for heat radiation as shown in FIG. 9A; a first reflow process is carried out by heating the circuit board 2 with the heat generating element 1 placed on the upper surface thereof as shown in FIG. 9(B); and the lead terminals 1a of the heat generating element 1 and the underside of the heat generating element 1 are respectively solder-connected to the land portions 6 and the copper foil flat pattern 3.

At this time, there are cases where the solder applied to the copper foil flat pattern 3 is melted to flow into the viaholes 4, spills out from the openings surrounded by a copper foil flat pattern 5 on an other surface 2b, and is solidified while bulging out at the openings, thereby forming the solder balls 7a as shown in FIG. 9C.

In this state, a second reflow process is carried out after cream solder is applied to land portions on the other surface 2b, whereby the copper foil pattern on the other surface 2b is solder-connected to terminals and an electronic part.

At this time, a metal mask 9 is mounted and the cream solder is applied by a squeegee 10 as shown in FIG. 9(D), but the metal mask 9 becomes uneven by the presence of the solder balls 7a.

Thus, there is a problem of damaging the metal mask 9 and squeegee 10 at the time of applying the cream solder.

Further, when the cream solder is heated by a reflow process, it is separated into solder and flux for facilitating the soldering. This flux flows into the viaholes 4 together with the molten solder to adhere to the copper foil flat pattern 5 on the underside. Since this flux is adhesive, the metal mask becomes difficult to remove after the cream solder is applied with the metal mask mounted on the other surface side, which presents a problem of reducing operability.

It is effective in preventing the formation of the solder balls 7a to close the through holes by filling them with resin beforehand as disclosed in Japanese Unexamined Patent Publication No. 2004-127992. However, this leads to an increased production cost because a resin applying step needs to be added.

The European patent application EP 0 920 055 A2 discloses a cooling apparatus having a printed circuit board provided on a first face with at least one component which produces heat and is arranged on a first large-area metallization. Further, the printed circuit board has a second large-area metallization on a face opposite the component, which is thermally conductively connected in the mounting area of the component to the first large-area metallization via through-holes. On the face opposite the component a thermally conductive plate is soldered to that area of the second large-area metallization which is provided with the through-holes.

Further, the German publication document DE 199 10 500 A1 discloses an electrical device comprising a printed circuit board located in a housing. Heat-generating electrical/electronic components are arranged one a first side of the printed circuit board. A plurality of plated through-holes electrically connect the first side with a second side of the printed circuit board, wherein heat sinks are arranged at the second side in the area of the through-holes. The remaining interior space of the housing is filled with a heat conducting, and electrically insulating sealing compound.

The US patent application publication US 2002/0131240 A1 discloses a heat dissipation structure of an integrated circuit including a circuit board provided with a plurality of through holes. The heat generated from the IC is transmitted to a first portion of a solder made of metal, which is located under the IC. The transmitted heat is then transmitted to a second portion of the solder, which is located within the through-holes, and to a third portion of the solder, which is attached to solder lands on the through-holes of a lower surface of the circuit board. The third portion of the solder serves as a heat sink.

Further, the Japanese patent application JP 2006-100483 A discloses a heat dissipation structure of a print wiring board. The printed wiring board with a circuit pattern formed at least on one surface thereof includes a heat dissipator of a heating component provided in the circuit pattern. The heat dissipator comprises a first heat dissipation pattern wherein the pattern of a part of the circuit pattern is expanded and formed to which an electrode of the heating component is connected. A second heat dissipation pattern has a size substantially coincident with the first heat dissipatation pattern, while facing the first heat dissipation pattern and formed on the other surface of the printed wiring board. A through hole penetrates the printed wiring board in a region where the first heat dissipation pattern and the second heat dissipation pattern are existent, and includes an electric conductor disposed on the internal peripheral surface of the printed wiring board to electrically connect the first heat dissipation pattern part and the second heat dissipation part.

In EP0139431 in figure 4 a chip carrier is soldered to land portions 41, 42 of a circuit board 30, where solder 43 applied to these land portions leaks out through the through-holes 37, 40 to land portions below the through-holes.

The present invention was developed in view of the above problems, and an object thereof is to improve the production process of a printed circuit board.

This object is solved according to the invention by the features of the independent claims. Preferred embodiments of the invention are subject of the dependent claims.

Accordingly, solder flown into one or more viaholes is advantageously prevented from being formed into solder balls largely protuberant on an other surface, so that a metal mask does not become uneven and the metal mask and a squeegee used for cream application are not damaged at the time of mounting the metal mask to apply cream solder to land portions on the other surface.

According to the invention, there is provided a method for producing a printed circuit board with at least one heat radiating structure, comprising the steps of:
preparing a printed circuit board having one or more conductor patterns and one or more land portions made of conductive foil formed on one or both surfaces of an insulating substrate, having at least one soldering land portion for heat radiation formed on a part of one surface to serve as a mounting surface for an electronic part and at least one land portion for solder absorption formed on the other surface substantially facing the one surface, and formed with one or more viaholes whose opposite ends make openings in the soldering land portion for heat radiation and the land portion for solder absorption,
placing a metal mask on the one surface and applying cream solder to the one or more land portions and the soldering land portion for heat radiation,
placing the electronic part substantially on the one surface, melting the cream solder in a first reflow process to solder-connect lead terminals of the electronic part and the one or more respective land portions, causing the molten solder at least partly leaking out toward the other surface through the one or more viaholes to at least partly flow to the land portion for solder absorption and substantially adhere to or near the openings in a substantially flat manner, and
placing a metal mask on the other surface of the printed circuit board, applying cream solder to the land portion for solder absorption in such a manner as to cover the solder solidified at or near the openings of the viaholes, and the cream solder is melted in a second reflow process to form a solder layer on the land portion for solder absorption,
wherein the step of placing the metal mask on the other surface of the printed circuit board comprises:
providing the metal mask on the other surface with an opening in a part facing the land portion for solder absorption including the openings of the one or more viaholes, and
mounting said metal mask on a solder resist surrounding the land portion for solder absorption,
wherein no heat radiating member is being soldered to the land portion for solder absorption by the solder layer on the land portion for solder absorption during the second reflow process.

According to a preferred embodiment of the invention, the method further comprises forming one or more solder resists on solder unnecessary parts of the one surface of the printed circuit board to at least partly surround the soldering land portion for heat radiation.

Preferably, the first reflow process comprises forming a solder layer at least partly adhering to the soldering land portion for heat radiation and the underside of the electronic part.

According to a further preferred embodiment of the invention, there is provided a method for producing a printed circuit board with a heat radiating structure, comprising the steps of:
preparing a printed circuit board having conductor patterns and land portions made of copper foil formed on both surfaces of an insulating substrate, having a soldering land portion for heat radiation formed on a part of one surface to serve as a mounting surface for an electronic part and a land portion for solder absorption formed on the other surface facing the one surface, and formed with viaholes whose opposite ends make openings in the soldering land portion for heat radiation and the land portion for solder absorption,
forming solder resists on solder unnecessary parts of the both surfaces of the printed circuit board to surround the soldering land portion for heat radiation and the land portion for solder absorption,
placing a metal mask on the one surface and applying cream solder to the land portions and the soldering land portion for heat radiation,
placing the electronic part on the one surface, melting the cream solder in a first reflow process to solder-connect lead terminals of the electronic part and the land portions, forming a solder layer adhering to the soldering land portion for heat radiation and the underside of the electronic part, and causing the molten solder leaking out toward the other surface through the viaholes to flow to the land portion for solder absorption and adhere to the openings in a flat manner, and
placing a metal mask on the other surface of the printed circuit board, applying cream solder to the land portion for solder absorption in such a manner as to cover the solder solidified at the openings of the viaholes, and the cream solder is melted in a second reflow process to form a solder layer on the land portion for solder absorption,
wherein the step of placing a metal mask on the other surface of the printed circuit board comprises:
providing the metal mask on the other surface with an opening in a part facing the land portion for solder absorption including the openings of the viaholes, and
mounting said metal mask on a solder resist surrounding the land portion for solder absorption,
wherein no heat radiating member is being soldered to the land portion for solder absorption by the solder layer on the land portion for solder absorption during the second reflow process.

As described above, if the solder melted in the first reflow process flows into the viaholes and leaks out from the openings at the other end side, the leaked-out solder spreads along the outer surface of the copper foil and deposits at the peripheries of the openings in a flat manner since the land portion for solder absorption is provided at these openings to expose the copper foil. Thus, the molten solder is solidified in a flat manner while surrounding the openings of the viaholes without becoming solder balls formed by the solidified solder protuberant at the openings of the viaholes.

Accordingly, when the metal mask is mounted on the other surface of this printed circuit board and the cream solder is applied, the metal mask is not deformed to become uneven since there are no largely protuberant solder balls. In addition, since the cream solder is applied also to the land portion for solder absorption, the metal mask is formed with openings in a part corresponding to the land portion for solder absorption, wherefore the metal mask does not become uneven.

Thus, the damage of a squeegee and the metal mask can be prevented in the process of applying the cream solder to the upper surface of the metal mask by the squeegee. Further, since the metal mask is not mounted on the land portion for solder absorption, there is no likelihood that the metal mask adheres because of flux and is made difficult to remove. In this way, problems that have occurred in the conventional production process can be solved, and production costs can be reduced by improving production efficiency in the production process.

Preferably, a thickness of the applied cream solder for the first reflow process is substantially equal to the thickness of the metal mask used in connection therewith.

Further preferably, the molten solder at least partly leaking out toward the other surface through the one or more viaholes forms one or more solder deposited portions having a projecting height which is smaller than thickness of the metal mask used in connection with the second reflow process.

Most preferably, in connection with the second reflow process the cream solder is applied at least to the land portion for solder absorption up to the substantially same height as the metal mask while preferably at least partly covering solder deposited portions on or near the openings of the one or more respective viaholes.

According to an example, a heat radiating structure for a printed circuit board is provided, wherein:
the printed circuit board is a double-sided circuit board having one or more conductor patterns provided on one or both surfaces thereof,
at least one soldering land portion for heat radiation is provided in an area, at least partly substantially facing the underside of an electronic part, of one surface of the printed circuit board where the electronic part is to be mounted, one or more, preferably a plurality of viaholes whose ends at one side make openings in the soldering land portion for heat radiation are formed to penetrate to the other surface of the printed circuit board, and at least one land portion for solder absorption is provided on the other surface of the printed circuit board where the other ends of the one or more, preferably the plurality of viaholes make openings,
at least one solder layer formed by reflowing cream solder at least partly applied to the soldering land portion for heat radiation is provided between the underside of the electronic part and the soldering land portion for heat radiation, and the solder is melted to at least partly leak out through the one or more viaholes, thereby at least partly spreading on the land portion for solder absorption and adhering to the land portion for solder absorption in a substantially flat manner, and
a solder layer formed by reflowing cream solder applied in such a manner as to at least partly cover the solder adhering in the substantially flat manner is provided on the land portion for solder absorption.

The heat radiating structure for the printed circuit board according to the above is preferably produced by the producing method according to the invention or a preferred embodiment thereof.

Specifically, it is preferable that the land portion for solder absorption at least partly substantially faces the soldering land portion for heat radiation in the thickness direction of the printed circuit board while preferably having substantially the same area as the soldering land portion for heat radiation.

Moreover, it is preferable that a plurality of viaholes are arranged at specified (predetermined or predeterminable) intervals in forward and backward directions and/or transverse direction, and that the outer edge of the land portion for solder absorption is at a specified distance from the viaholes located at the outer ends in forward and backward direction and/or transverse direction.

If the land portion for solder absorption has such a wide area including the openings of all the viaholes and the outer edge thereof is at the specified distance from the openings of the viaholes located closest to this outer edge as described, the molten solder and flux leaking out from the openings of the viaholes can be reliably prevented from adhering to the outer surface of the solder resist at the outer periphery.

Preferably, one or more lead terminals projecting from the outer side surface of the electronic part are respectively solder-connected to one or more respective land portions provided on the one surface of the printed circuit board and the electronic part includes a heat radiating member formed of a radiation slug or heat sink on the underside thereof, and the solder layer preferably formed on the soldering land portion for heat radiation is secured in surface contact with the heat radiating member.

If the electronic part is provided with the heat radiating member on its underside as above, the heat radiating member can be reliably brought substantially into surface contact with the solder layer formed on the outer surface of the soldering land portion for heat radiation, wherefore the heat radiating property of the electronic part can be reliably improved.

As described above, according to the present invention, the soldering land portion for heat radiation is provided at the underside of the electronic part generating heat and the land portion for solder absorption is provided on the other surface electrically connected to the soldering land portion through the viaholes. Thus, even if the solder in the solder layer formed between the underside of the electronic part and the soldering land portion for heat radiation is melted by heating and leaks out to the other side through the hollow parts of the viaholes, this solder spreads along the surface of the land portion for solder absorption, thereby preventing the formation of protuberant solder balls. As a result, the damage of the metal mask and squeegee can be prevented when the metal mask is mounted on the other surface and the cream solder is applied by the squeegee. Therefore, production efficiency can be improved.

These and other objects, features and advantages of the present invention will become more apparent upon reading of the following detailed description of preferred embodiments and accompanying drawings. It should be understood that even though embodiments are separately described, single features thereof may be combined to additional embodiments.
FIGS. 1 show an essential portion of a printed circuit board according to the invention, wherein FIG. 1(A) is a section, FIG. 1(B) is a plan view and FIG. 1(C) is a bottom view,
FIGS. 2 are views of a circuit board with double-sided conductor patterns and viaholes showing a method for producing the printed circuit board, wherein FIG. 2(A) is a plan view, FIG. 2(B) is a section and FIG. 2(C) is a bottom view,
FIG. 3 is a section showing a state where a metal mask is mounted on one surface of the printed circuit board of FIGS. 2,
FIGS. 4(A) and 4(B) are sections showing a state where cream solder is applied with the metal mask mounted,
FIG. 5 is a section showing a state where an electronic part is placed after the application of the cream solder,
FIG. 6 is a section showing a state of a first reflow process,
FIGS. 7(A) and 7(B) are sections showing a state where a metal mask is mounted on the other surface and cream solder is applied,

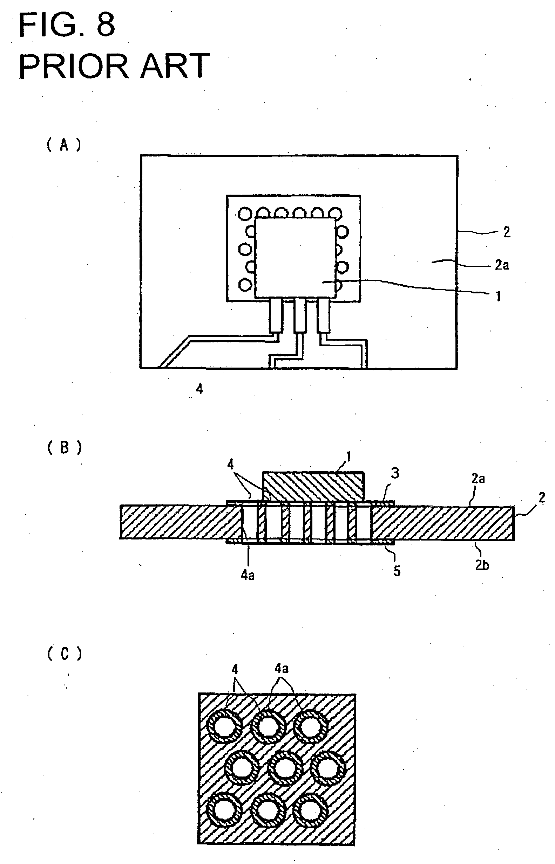

FIGS. 8(A) to 8(C) are sections showing a prior art,
FIGS. 9(A) to 9(C) are views showing a conventional producing method.

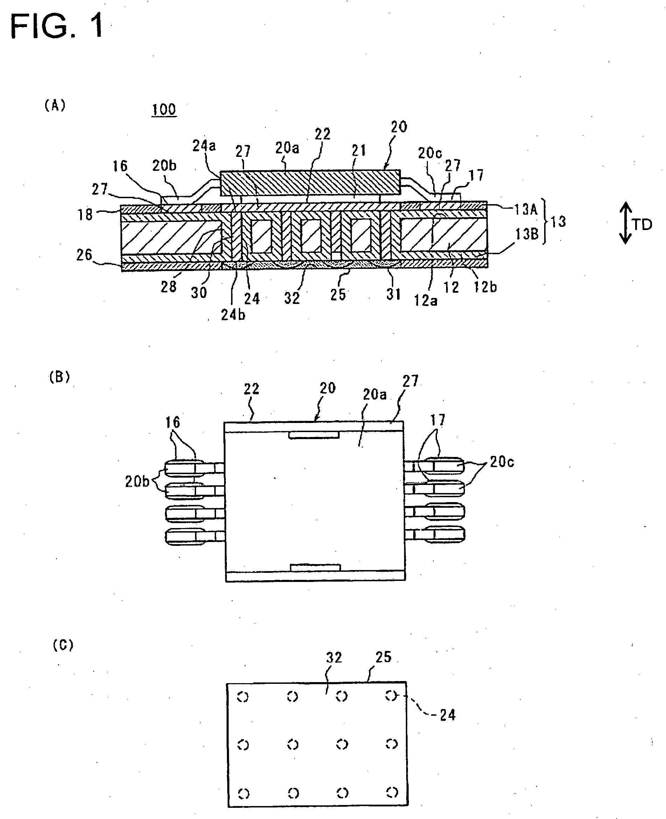

Hereinafter, one preferred embodiment of the present invention is described with reference to FIGS. 1 to 7.

FIGS. 1(A) to 1(C) show a printed circuit board 100.

The printed circuit board 100 preferably is a double-sided circuit board having one or more conductor patterns 13 (13A, 13B) made of conductive material, preferably conductive foil material such as copper foil on one and/or other surfaces 12a, 12b of an insulating substrate 12 made of insulating material such as glass epoxy, and an electronic part 20 including an IC chip, to which preferably a large current is or can be applied, is mounted or mountable on the one surface 12a.

Preferably the plurality of lead terminals 20b, 20c project from (preferably the bottom ends or edges of) the (preferably substantially opposite) lateral (left and/or right) surface(s) of a case 20a of the electronic part 20, and a heat sink 21 is attached to a mounting side to be oriented facing towards the printed circuit board 100 or the one surface 12 a (preferably to the underside or lower surface) of the electronic part 20. The lead terminals 20b, 20c of the electronic part 20 are to be electrically connected, preferably solder-connected to one or more land portions 16, 17 of the one or more conductor patterns on the one surface 12a, thereby mounting the electronic part 20 on the one surface 12a.

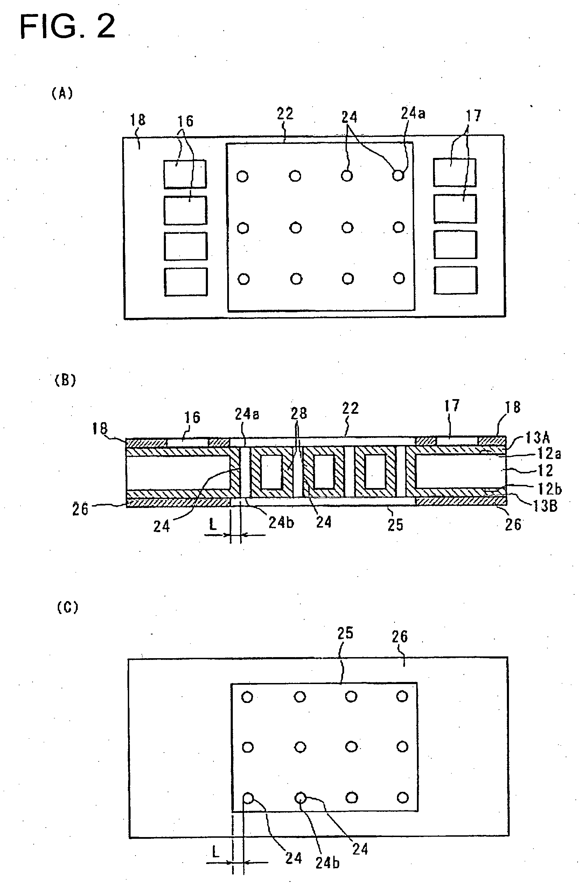

On the one surface 12a of the printed circuit board 100 facing the mounting side (preferably the underside) of the electronic part 20 where the heat sink 21 is provided, the copper foil is at least partly exposed by providing a connecting portion, preferably a soldering land portion 22, for heat radiation surrounded by a solder resist 18. One or more, preferably a plurality of viaholes or conductive through holes 24 (particularly holes at least partly having a conductive inner surface, such as by plating, which are not (predominantly) used as component holes but serve as interlayer connections and/or for connecting conductive layers or patterns on two surfaces particularly like "Through Hole Plated" (THPlated)) each having a one-end opening in or close to this soldering land portion 22 for heat radiation are formed preferably substantially in a substantially regular patter or a matrix array at the substantially same intervals in forward and backward directions and/or transverse direction. In this embodiment, as show in FIG. 2, four viaholes 24 are arranged in transverse direction and three are arranged in forward and backward directions, thereby providing a total of twelve viaholes 24. It should be noted that the number of the viaholes 24 can be suitably selected according to the size of the electronic part 20 and/or the heat to be dissipated.

On the other surface 12b of the printed circuit board 12 where other-end openings 24b of the viaholes 24 are formed, the conductive foil (preferably the copper foil) is at least partly exposed by providing at least one land portion 25 for solder absorption preferably having substantially the same area as the soldering land portion 22 for heat radiation and/or preferably substantially facing the soldering land portion 22 in thickness direction TD, and the exposed part is at least partly surrounded by a solder resist 26.

The outer periphery of the land portion 25 for solder absorption determined by the solder resist 26 is at a specified (predetermined or predeterminable) distance L from the viaholes 24 closest to this outer periphery. The land portion 25 for solder absorption and the soldering land portion 22 for heat radiation have substantially the same rectangular shape as the outer shape of the case 20a of the electronic part 20.

A solder layer 27 preferably formed by reflowing the cream solder is provided between the soldering land portion 22 for heat radiation and/or the heat sink 21 on the side where the electronic part 20 is to be mounted. Further, the solder molten during the reflowing at least partly flows into hollow parts enclosed by conductive layers 28 (preferably formed by plating) on the inner circumferential surfaces of the viaholes 24 making openings in the soldering land portion 22 for heat radiation, whereby these hollow parts are at least partly filled with solder 30. This solder 30 at least partly flows or can flow out from the openings 24b of the viaholes 24 on the other surface and can spread at least partly along the copper foil surface of the land portion 25 for solder absorption to become substantially flat (in particular such that the lateral extension is at least about three times more than the height extension, more preferably at least about four times, most preferably at least about five times) and low mountain-shaped solder deposited portions 31.

A solder layer 32 is provided on the land portion 25 for solder absorption by applying the cream solder in such a manner as to cover the solder deposited portions 31 and/or reflowing the cream solder.

Next, a method for producing the double-sided printed circuit board 100 is described with reference to FIGS. 2 to 7.

First, one or more through holes to become the viaholes are formed at specified (predetermined or predeterminable) positions of a copper-clad laminate, in which copper foils are provided as preferred conductive foils on the both surfaces of the insulating substrate 12 made of insulating material such as glass epoxy, preferably by means of a drill, a laser cutting tool or the like, and the conductive layers 28 are at least partly formed on the inner circumferential surfaces of these through holes preferably by plating to form the one or more viaholes 24. Further, the one or more conductive (preferably copper) foil patterns 13A, 13B are formed to have specified (predetermined or predeterminable) circuit configurations on the both surfaces 12a, 12b of the circuit board preferably by etching. Subsequently, the one or more solder resists 18, 26 are formed on the (preferably both) surface(s) 12a, 12b while preferably leaving the soldering portions, thereby attaining a state shown in FIGS. 2(A) to 2(C).

As shown in FIGS. 2(A) to 2(C), the (preferably substantially rectangular) soldering land portion 22 for heat radiation, where the one-end openings 24a of a plurality of viaholes 24 are, is at least partly formed in a part to substantially face a placing portion of the electronic part 20 on the one surface 12a where the electronic part 20 is to be mounted, and the soldering land portion 22 for heat radiation is at least partly, preferably substantially fully surrounded by the solder resist 18. Further, the copper foils of the land portions 16, 17 for solder connection with the lead terminals of the electronic part 20 are at least partly exposed at the (preferably substantially opposite) lateral (left and/or right) side(s) of the soldering land portion 22 for heat radiation.

On the other hand, the land portion 25 for at least partial solder absorption including all the other-end openings 24b of the viaholes 24 is formed on the other surface 12b while being at least partly, preferably substantially fully surrounded by the solder resist 26. The land portion 25 for solder absorption preferably is formed to have the substantially same shape as the soldering land portion 22 for heat radiation while substantially facing the soldering land portion 22 in the thickness direction TD of the insulating substrate 12.

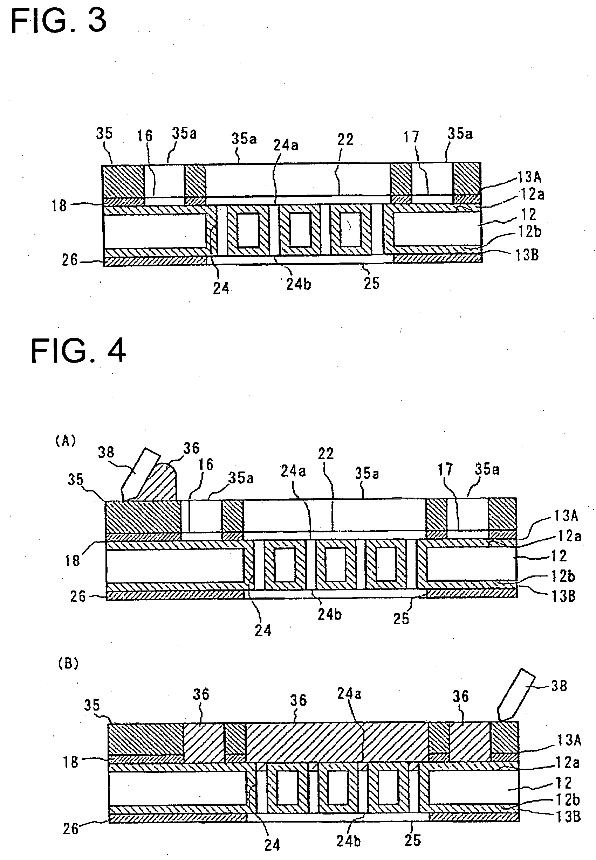

Subsequently, as shown in FIG. 3, a metal mask 35 is mounted to expose substantially only the soldering portion on the one surface 12a where the electronic part 20 is to be mounted. The metal mask 35 has one or more openings 35a in its surface substantially facing parts where the solder resist 18 is not provided, i.e. the soldering land portion 22 for heat radiation and the land portions 16, 17.

Subsequently, as shown in FIGS. 4(A) and 4(B), cream solder 36 is put on one side of the outer surface of the metal mask 35 and applied to the outer surface of the metal mask 35 by a squeegee or resilient scraping tool 38. The cream solder 36 is at least partly applied to the outer surface(s) of the soldering land portion 22 for heat radiation and/or the land portions 16, 17 at or near the openings 35a. The thickness of the applied cream solder 36 preferably is substantially equal to the thickness of the metal mask 35.

The metal mask 35 is removed after the cream solder 36 is applied.

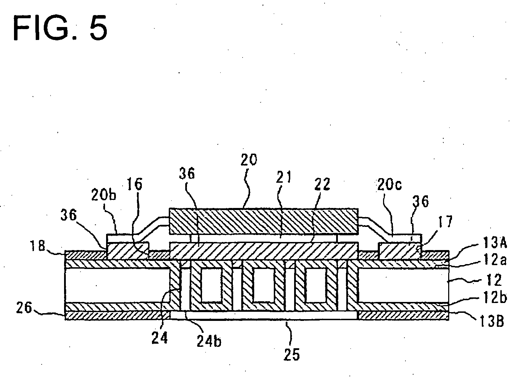

Subsequently, as shown in FIG. 5, the electronic part 20 is placed, the leading terminals 20b, 20c thereof are brought substantially into contact with the cream solder 36 on the outer surfaces of the land portions 16, 17, and the heat sink 21 on the underside of the electronic part 20 is brought or bringable into contact with the outer surface of the cream solder 36 at least partly applied on the outer surface of the soldering land portion 22 for heat radiation.

Subsequently, heating is performed at a specified (predetermined or predeterminable) temperature using heating means (not shown) to melt the cream solder 36, thereby performing a first reflow process.

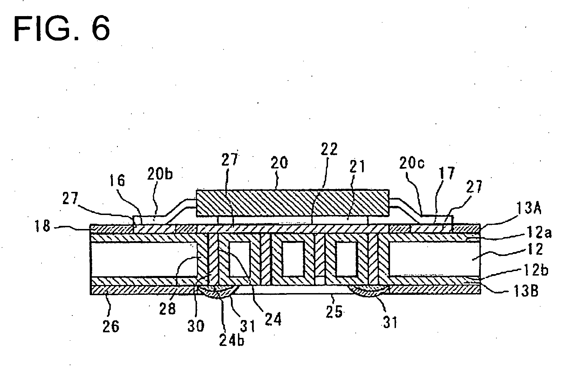

By this first reflow process, the one or more lead terminals 20b, 20c of the electronic part 20 are solder-connected or - connectable to the land portions 16, 17 using the solder in the cream solder 36 as shown in FIG. 6.

Further, the cream solder 36 at least partly applied on the soldering land portion 22 for heat radiation is substantially melted to adhere or contact to the heat sink 21 and the copper foil of the soldering land portion 22 for heat radiation. Thereafter, the cream solder 36 is solidified to become the solder layers 27 preferably upon being taking out from a reflow oven.

The molten cream solder 36 flows at least partly into the hollow parts of part or all the viaholes 24 at least partly exposed at the soldering land portion 22 for heat radiation, at least partly fills up the hollow parts while substantially adhering to the conductive layers 28 on the inner circumferential surfaces, and are thereafter solidified to become the solders 30.

The molten solder flown into the viaholes 24 may also at least partly flow out from the openings 24b at the land portion 25 for solder absorption, but at least partly spreads along the copper foil since the copper foil is exposed on the surface of the land portion 25 for solder absorption. As a result, the molten solder at least partly spreads to form flat mountain-shaped projections about the openings 24b instead of becoming protuberant solder balls as in the prior art.

Thereafter, when the molten solder is solidified, the flat solder deposited portions 31 are formed at the openings of the viaholes 24 at the land portion 25 for solder absorption. The height of the solder deposited portions 31 preferably is smaller than thickness "t" of a metal mask 40 to be described later.

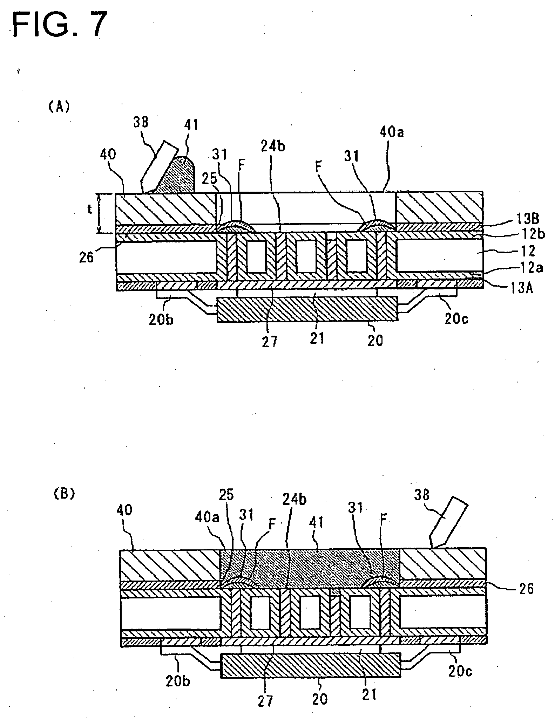

Subsequently, as shown in FIGS. 7(A) and 7(B), the metal mask 40 is mounted substantially on or near the other surface 12b of the printed circuit board 12 and cream solder 41 is applied preferably by the squeegee 38.

Since the metal mask 40 has an opening 40a in its part facing the land portion 25 for solder absorption, and the height of the solder deposited portions 31 is shorter than the height of the metal mask 40, the metal mask 40 can cover in a flat state substantially without becoming uneven due to solder balls as in the prior art. Thus, the cream solder 41 can be smoothly applied without damaging the metal mask 40 and squeegee 38 in the process of applying the cream solder 41 by the squeegee 38.

The cream solder 41 is applied to the land portion 25 for solder absorption preferably up to the substantially same height as the metal mask 40 while covering the solder deposited portions 31 centered on the openings 24b of the respective viaholes 24. Thus, even if flux F leaks out to the outer surfaces of the solder deposited portions 31, it is substantially embedded in the cream solder 41 and does not leak out to the outer surface of the cream solder 41.

The metal mask 40 is removed after the application of the cream solder 41. At this time, the flux F substantially does not come into contact with the metal mask 40 since the metal mask 40 has the opening and the solder deposited portions 31 are substantially embedded in the cream solder 41.

Thereafter, a second reflow process is carried out using the heating means to melt the cream solder 41, whereby the cream solder 41 is secured to the solder deposited portions 31 of the land portion 25 for solder absorption and the copper foil of the land portion 25 for solder absorption and is, thereafter, solidified to form the solder layer 32.

In the case of production by the above method, since the land portion 25 for solder absorption connected to the soldering land portion 22 for heat radiation on the mounting surface for the electronic part 20 through the one or more viaholes 24 is provided on the other surface, the molten solder flown out to the other surface from the viaholes 24 can at least partly spread substantially along the copper foil surface of the land portion 25 for solder absorption, thereby being able to prevent the formation of the solder balls projecting from the other surface.

Further, the land portion 25 for solder absorption is provided in a part where the molten solder flows out from the viaholes 24, the metal mask 40 to be mounted on the solder resist 26 on the other surface has the opening in its part facing the land portion 25 for solder absorption and, hence, the metal mask 40 is not mounted on the solder deposited portions 31 formed by the flown-out and solidified solder. Thus, there is no likelihood of deforming the metal mask due to solder balls or protuberances, which have been a problem of the prior art. As a result, the damage of the metal mask 40 and squeegee 38 can be prevented at the time of applying the cream solder 41 to the outer surface of the metal mask 40 by the squeegee 38, wherefore production efficiency can be improved.

Accordingly, there is provided a printed circuit board with a heat radiating structure having a solder layer for heat radiation at one side of an electronic part for radiating heat toward an other surface side through viaholes, which can prevent problems at the time of production caused by solder balls formed at openings of viaholes at the other surface. In particular, in a double-sided printed circuit board, a soldering land portion for heat radiation is provided in a part, which serves as a mounting surface for an electronic part, a land portion for solder absorption is formed on the other surface facing the mounting surface, and viaholes are provided which makes openings in the soldering land portion for heat radiation and the land portion for solder absorption at the opposite ends. Molten solder flowing out from the openings of the viaholes is caused to spread on the land portion for solder absorption, thereby suppressing the formation of solder balls, and cream solder is applied to the outer surface of the land portion for solder absorption in such a manner as to embed the solder, thereby forming a solder layer.

The present invention is not limited to the above embodiment. For example, even in the case where lead terminals project from the entire circumference of the case of the electronic part, a soldering land portion may be provided in an area surrounded by land portions solder-connected to the lead terminals with the outer periphery thereof determined by a solder resist

Further, an area of the land portion for solder absorption on the other surface may be made larger than that of the soldering land portion for heat radiation as long as such an enlargement is possible in terms of space. In such a case, heat radiation capability can be further improved.

Furthermore, the land portion for solder absorption having a large area may double as a ground circuit or a power supply circuit.

### LIST OF REFERENCE NUMERALS

12 ... insulating substrate
   12a ... one surface at an electronic part mounting side
   12b ... other surface
13(13A,13B) ... conductor pattern
16, 17... land portion
18,26... solder resist
20 ... electronic part
   20b, 20c ... lead terminal
21 ... heat sink
22 ... soldering land portion for heat radiation
24 ... viahole
25 ... land portion for solder absorption
27, 32... solder layer
28 ... conductive layer on the inner circumferential surface of the viahole
31 ... solder deposited portion
35,40... metal mask
36,41... cream solder
38 ... squeegee
100 ... printed circuit board

## Claims

1. A method for producing a printed circuit board (100) with at least one heat radiating structure, comprising the steps of:
preparing a printed circuit board (100) having one or more conductor patterns (13) and one or more land portions (16; 17) made of conductive foil formed on one or both surfaces (12a; 12b) of an insulating substrate (12), having at least one soldering land portion (22) for heat radiation formed on a part of one surface to serve as a mounting surface for an electronic part (20) and at least one land portion (25) for solder absorption formed on the other surface (12b) substantially facing the one surface (12a), and formed with one or more viaholes (24) whose opposite ends make openings (24a, 24b) in the soldering land portion (22) for heat radiation and the land portion (25) for solder absorption,
placing a metal mask (35) on the one surface (12a) and applying cream solder (36) to the one or more land portions (16; 17) and the soldering land portion (22) for heat radiation,
placing the electronic part (20) substantially on the one surface, melting the cream solder (36) in a first reflow process to solder-connect lead terminals (20b; 20c) of the electronic part (20) and the one or more respective land portions (16; 17), causing the molten solder at least partly leaking out toward the other surface (12b) through the one or more viaholes (24) to at least partly flow to the land portion (25) for solder absorption and substantially adhere to or near the openings (24b) in a substantially flat manner, and
placing a metal mask (40) on the other surface (12b) of the printed circuit board (100), applying cream solder (41) to the land portion (25) for solder absorption in such a manner as to cover the solder solidified at or near the openings (24b) of the viaholes (24), and the cream solder (41) is melted in a second reflow process to form a solder layer (32) on the land portion (25) for solder absorption,
wherein the step of placing the metal mask (40) on the other surface (12b) of the printed circuit board (100) comprises:
providing the metal mask (40) on the other surface (12b) with an opening in a part facing the land portion (25) for solder absorption including the openings (24b) of the one or more viaholes (24), and
mounting said metal mask (40) on a solder resist (26) surrounding the land portion (25) for solder absorption,
wherein no heat radiating member is being soldered to the land portion (25) for solder absorption by the solder layer (32) on the land portion (25) for solder absorption during the second reflow process.

2. A method according to claim 1, further comprising forming one or more solder resists (18) on solder unnecessary parts of the one surface of the printed circuit board (100) to at least partly surround the soldering land portion (22) for heat radiation.

3. A method according to one or more of the preceding claims, wherein the first reflow process comprises forming a solder layer at least partly adhering to the soldering land portion (22) for heat radiation and the underside of the electronic part (20).

4. A method according to one or more of the preceding claims, wherein a thickness of the applied cream solder (36) for the first reflow process is substantially equal to the thickness of the metal mask (35) used in connection therewith.

5. A method according to one or more of the preceding claims, wherein the molten solder (36) at least partly leaking out toward the other surface through the one or more viaholes (24) forms one or more solder deposited portions (31) having a projecting height which is smaller than thickness (t) of the metal mask (40) used in connection with the second reflow process.

6. A method according to one or more of the preceding claims, wherein in connection with the second reflow process the cream solder (41) is applied at least to the land portion (25) for solder absorption up to the substantially same height as the metal mask (40) while preferably at least partly covering solder deposited portions (31) on or near the openings (24b) of the one or more respective viaholes (24).

## Patentansprüche

1. Ein Verfahren zur Herstellung einer gedruckten Schaltungsplatine bzw. Leiterplatte (100) mit mindestens einer Wärme abstrahlenden Struktur, das die folgenden Schritte umfasst:
vorbereiten einer Leiterplatte (100), die ein oder mehrere Leitermuster (13) aufweist und einen oder mehrere Kontaktflächenabschnitte (*land portions*) (16; 17), die aus einer leitfähigen Folie hergestellt werden, die auf einer oder beiden Oberflächen (12a; 12b) eines isolierenden Substrats (12) gebildet wird, das mindestens einen Löt-Kontaktflächenabschnitt (22) zur Wärmeabstrahlung aufweist, der auf einem Teil einer Oberfläche gebildet ist, um als Montagefläche für ein elektronisches Bauteil (20) zu dienen, und mindestens ein Kontaktflächenabschnitt (25) zur Lötmittelabsorption, der auf der anderen Fläche (12b) gebildet wird, die der einen Fläche (12a) im Wesentlichen gegenüberliegt und mit einem oder mehreren Durchgangslöchern (24) gebildet wird, deren gegenüberliegenden Enden Öffnungen (24a, 24b) im Löt-Kontaktflächenabschnitt (22) zur Wärmeabstrahlung realisieren, und den Kontaktflächenabschnitt (25) zur Lötmittelaufnahme,
platzieren einer Metallmaske (35) auf die eine Oberfläche (12a) und anbringen von Weichlotpaste (36) an einen oder mehreren Kontaktflächenabschnitten (16; 17) und einen Löt-Kontaktflächenabschnitt (22) zur Wärmeabstrahlung,
platzieren des elektronischen Bauteils (20) im Wesentlichen auf die eine Oberfläche, schmelzen der Weichlotpaste (36) in einem ersten *Reflow*-Prozess, um Leiteranschlüsse (20b; 20c) des elektronischen Bauteils (20) und entsprechend den einen oder die mehreren Kontaktflächenabschnitte (16; 17) durch Löten zu verbinden, was bewirkt, dass zumindest ein Teil des geschmolzenen Lots zur anderen Oberfläche (12b) durch das eine oder die mehreren Durchgangslöcher (24) nach außen dringt, um zumindest teilweise zum Kontaktflächenabschnitt (25) zur Lötmittelabsorption zu fließen und im Wesentlichen an den oder in der Nähe der Öffnungen (24b) auf im Wesentlichen flache Weise haften zu bleiben, und
platzieren einer Metallmaske (40) auf die andere Oberfläche (12b) der Leiterplatte (100), anbringen von Weichlotpaste (41) an den Kontaktflächenabschnitt (25) zur Lötmittelabsorption, sodass das verfestigte Lot an den oder in der Nähe der Öffnungen (24b) der Durchgangslöcher (24) bedeckt wird und die Weichlotpaste (41) wird in einem zweiten *Reflow*-Prozess geschmolzen, um eine Lotschicht (32) auf dem Kontaktflächenabschnitt (25) zur Lötmittelabsorption zu bilden,
wobei der Platzierungs-Schritt der Metallmaske (40) auf die andere Oberfläche (12b) der Leiterplatte (100) Folgendes umfasst:
bereitstellen der Metallmaske (40) auf der anderen Oberfläche (12b) mit einer Öffnung in einem Teil, die dem Kontaktflächenabschnitt (25) zur Lötmittelabsorption zugewandt ist, einschließlich der Öffnungen (24b) des einen oder der mehreren Durchgangslöcher (24), und
montieren der genannten Metallmaske (40) auf einem Lötresist (26), der den Kontaktflächenabschnitt (25) zur Lötmittelabsorption umgibt,
wobei kein Wärme abstrahlendes Element an den Kontaktflächenabschnitt (25) zur Lötmittelabsorption durch die Lotschicht (32) auf den Kontaktflächenabschnitt (25) zur Lötmittelabsorption während des zweiten *Reflow-*Prozesses angelötet wird.

2. Ein Verfahren nach Anspruch 1, das des Weiteren die Bildung eines oder mehrerer Lötresists (18) auf Teilen der einen Oberfläche der Leiterplatte (100) umfasst, auf denen eine Lötung nicht notwendig ist, um zumindest teilweise den Löt-Kontaktflächenabschnitt (22) zur Wärmeabstrahlung zu umgeben.

3. Ein Verfahren nach einem oder mehreren der vorhergehenden Ansprüche, wobei der erste *Reflow*-Prozess die Bildung einer Lotschicht umfasst, die zumindest teilweise am Löt-Kontaktflächenabschnitt (22) zur Wärmeabstrahlung anhaftet und an der Unterseite des elektronischen Bauteils (20).

4. Ein Verfahren nach einem oder mehreren der vorhergehenden Ansprüche, wobei eine Dicke der aufgebrachten Weichlotpaste (36) für den ersten *Reflow*-Prozess mit der Dicke der Metallmaske (35), die in diesem Zusammenhang verwendet wird, im Wesentlichen gleich ist.

5. Ein Verfahren nach einem oder mehreren der vorhergehenden Ansprüche, wobei das geschmolzene Lot (36), das zumindest teilweise zur anderen Oberfläche durch das eine oder die mehreren Durchgangslöcher (24) nach außen tritt, einen oder mehrere Abschnitte mit aufgebrachtem Lot (*solder deposited portions*) (31) bildet, die eine vorstehende Höhe aufweisen, die geringer ist als die Dicke (t) der Metallmaske (40) ist, die im Zusammenhang mit dem zweiten *Reflow-*Prozess verwendet wird.

6. Ein Verfahren nach einem oder mehreren der vorhergehenden Ansprüche, wobei die Weichlotpaste (41), im Zusammenhang mit dem zweiten *Reflow*-Prozess, zumindest auf den Kontaktflächenabschnitt (25) zur Lötmittelabsorption bis hin zur im Wesentlichen gleichen Höhe aufgebracht wird, wie die Metallmaske (40) wobei vorzugsweise zumindest teilweise Abschnitte mit aufgebrachtem Lot (31) an oder in der Nähe der Öffnungen (24b) des einen oder der mehreren Durchgangslöcher (24) abgedeckt werden.

## Revendications

1. Un procédé pour produire une carte de circuit intégré (100) avec au moins une structure de rayonnement thermique, comprenant les étapes suivantes, consistant à :
préparer une carte de circuit intégré (100) présentant un ou plusieurs motifs conducteurs (13) et une ou plusieurs portions de plage (16 ; 17) constituées d'une feuille conductrice formée sur une ou les deux surfaces (12a ; 12b) d'un substrat isolant (12), présentant au moins une portion de plage de brasage (22) pour le rayonnement thermique formée sur une partie d'une surface pour servir de surface de montage pour un composant électronique (20), et au moins une portion de plage (25) pour l'absorption de l'apport de brasage formée sur l'autre surface (12b) faisant sensiblement face à ladite surface (12a), et formée avec un ou plusieurs trous traversants (24), dont les extrémités opposées constituent des ouvertures (24a, 24b) dans la portion de plage de brasage (22) pour le rayonnement thermique et la portion de plage (25) pour l'absorption de l'apport de brasage,
placer un masque métallique (35) sur ladite surface (12a) et appliquer de la brasure en crème (36) à la ou les portions de plage (16 ; 17) et à la portion de plage de brasage (22) pour le rayonnement thermique,
placer le composant électronique (20) essentiellement sur ladite surface, mettre en fusion la brasure en crème (36) dans un premier processus de refusion pour braser-connecter des bornes de connexion (20b ; 20c) du composant électronique (20) et la ou les portions de plage (16 ; 17), amenant la brasure fondue à refluer au moins partiellement vers l'autre surface (12b) à travers le ou les trous traversants (24) pour s'écouler au moins partiellement vers la portion de plage (25) pour l'absorption de l'apport de brasage et adhérer essentiellement aux ou à proximité des ouverture (24b) d'une manière essentiellement plate, et
placer un masque métallique (40) sur l'autre surface (12b) de la carte de circuit intégré (100), appliquer de la brasure en crème (41) à la portion de plage (25) pour l'absorption de l'apport de brasage de manière à couvrir la brasure solidifiée auprès ou à proximité des ouvertures (24b) des trous traversants (24), et la brasure en crème (41) est fondue dans un deuxième processus de refusion pour former une couche de brasure (32) sur la portion de plage (25) pour l'absorption de l'apport de brasage,
sachant que l'étape consistant à placer le masque métallique (40) sur l'autre surface (12b) de la carte de circuit intégré (100) comprend le fait de :
fournir le masque métallique (40) sur l'autre surface (12b) avec une ouverture dans une partie (part) faisant face à la portion de plage (25) pour l'absorption de l'apport de brasage incluant les ouvertures (24b) du ou des trous traversants (24), et
monter ledit masque métallique (40) sur une épargne de brasage (26) qui entoure la portion de plage (25) pour l'absorption de l'apport de brasage,
sachant qu'aucun élément de rayonnement thermique n'est soudé ou encore brasé à la portion de plage (25) pour l'absorption de l'apport de brasage par la couche de brasure (32) sur la portion de plage (25) pour l'absorption de l'apport de brasage pendant le deuxième processus de refusion.

2. Un procédé d'après la revendication 1, comprenant en outre le fait de former une ou plusieurs épargnes de brasage (18) sur des parties où le brasage est superflu sur ladite surface de la carte de circuit intégré (100) pour entourer au moins partiellement la portion de plage de brasage (22) pour le rayonnement thermique.

3. Un procédé d'après une ou plusieurs des revendications précédentes, sachant que le premier processus de refusion comprend le fait de former une couche de brasure adhérant au moins partiellement à la portion de plage de brasage (22) pour le rayonnement thermique et à la face inférieure du composant électronique (20).

4. Un procédé d'après une ou plusieurs des revendications précédentes, sachant qu'une épaisseur d'une brasure en crème (36) appliquée pour le premier processus de refusion est essentiellement égale à l'épaisseur du masque métallique (35) utilisé dans le cadre de ce processus.

5. Un procédé d'après une ou plusieurs des revendications précédentes, sachant qu'une brasure fondue (36) refluant au moins partiellement vers l'autre surface à travers le ou les trous traversants (24), forme une ou plusieurs portions à brasure déposée (31) présentant une hauteur de saillie qui est inférieure à l'épaisseur (t) du masque métallique (40) utilisé dans le cadre du deuxième processus de refusion.

6. Un procédé d'après une ou plusieurs des revendications précédentes, sachant que dans le cadre du deuxième processus de refusion la brasure en crème (41) est appliquée au moins à la portion de plage (25) pour l'absorption de l'apport de brasage jusqu'à essentiellement la même hauteur que le masque métallique (40) de préférence tout en couvrant au moins partiellement des portions à brasure déposée (31) sur ou à proximité des ouvertures (24b) du ou des trous traversants (24) correspondants.
